(19) **Europäisches Patentamt / European Patent Office / Office européen des brevets**

(11) **EP 2 996 160 A1**

(12) ## EUROPEAN PATENT APPLICATION
published in accordance with Art. 153(4) EPC

(43) Date of publication:
**16.03.2016 Bulletin 2016/11**

(21) Application number: **14794838.4**

(22) Date of filing: **04.05.2014**

(51) Int Cl.:
**H01L 31/042** *(2006.01)*   **H01L 31/18** *(2006.01)*

(86) International application number:
**PCT/CN2014/076723**

(87) International publication number:
**WO 2014/180281 (13.11.2014 Gazette 2014/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **07.05.2013 CN 201310164812**

(71) Applicant: **Shanghai Solar Investment Management Partnerships Shanghai 201202 (CN)**

(72) Inventors:
• **YANG, Liyou**
  **Plainsboro, New Jersey 08536 (US)**
• **WANG, Hao**
  **Shanghai 201103 (CN)**

(74) Representative: **Samson & Partner Patentanwälte mbB**
**Widenmayerstraße 6**
**80538 München (DE)**

(54) **THIN-FILM SOLAR CELL PANEL AND MANUFACTURING METHOD THEREFOR**

(57) The present invention provides a thin film solar cell panel and a manufacturing method thereof. The thin film solar cell panel comprises a substrate (10), a first electrode (20) disposed on the substrate (10), a photoelectric conversion layer (30) disposed on the first electrode (20), a second electrode (40) disposed on a photoelectric conversion layer (30) and a gate electrode (50) on the second electrode (40). The substrate (10) is an ultra-thin glass substrate with a thickness of 0.1-1mm. The ultra-thin glass substrate has a bending capacity, and a minimum bending radius thereof reaches below 10cm. The first electrode (20) is continuously disposed on the substrate (10) during its formation. Light transmittance of the thin film solar cell panel of the present invention is enhanced, and the thin film solar cell panel can be conveniently used to manufacture a bending solar cell component. Furthermore, in the present invention, the manufacturing method of the bendable thin film solar cell panel is improved so as to avoid increase of additional costs, and to greatly increase general applicability of related equipment and the manufacturing process method of the present invention onto various bendable thin film solar cell panels.

**FIG. 5**

EP 2 996 160 A1

## Description

The present invention relates to the field of solar photovoltaic products, and particularly to a thin film solar cell panel and a manufacturing method thereof.

BACKGROUND OF THE INVENTION

A thin film solar cell has experienced a long development process from its invention to mass commercialization. In 1976, the first amorphous silicon thin film solar cell was successfully developed by Radio Corporation of America (RCA). After entering the mid 90s of the last century, with continuous progress of semiconductor manufacturing equipment and manufacturing technology, a highly efficient laminated silicon-based thin film solar cell is made to achieve large-scale commercial production, and optical absorption material of the silicon-based thin film solar cell was developed from an original homogeneous structure of amorphous silicon to a heterogeneous structure composed of amorphous silicon, polycrystalline silicon and monocrystalline silicon. In addition to the silicon-based thin film solar cell, thin film solar cells based on inorganic semiconductor compounds such as cadmium sulfide, gallium arsenide and copper-indium-gallium-tin, etc., and thin film solar cells based on organic materials such as polythiophene and fullerene derivatives, etc., were developed richly and rapidly in recent years, and all of them have a broad application prospect.

Compared with a crystalline silicon solar cell, the thin film solar cell has many advantages such as beautiful appearance, high degrees of production automation, bending flexibility and transparency, etc. Therefore, in addition to large-scale grids and independent power generation applications, the thin film solar cell is more suitable for making various small and flexible photovoltaic products. With advancement of industrialization progress and continuous decline in cost, applications of thin film solar cell products emerge endlessly, are increasingly widespread, and gradually go deep into many aspects of people's daily lives. In the field of solar cells used for cars, for example, there have been continuous patent applications filed since 1990s in the 20th century. For instance, U.S. patent No. US5,602,457 discloses a technology that a solar cell is arranged in the windshield of a car for charging a storage battery in the car, and European patent No. EP 0393437 discloses another technology by which cars are provided with an auxiliary solar power system for driving air conditioning systems in the cars to reduce temperature in the cars when the cars are exposed in sunshine. However, the technologies publicly disclosed by the patents above all use traditional manufacturing methods of the crystalline silicon solar cell to form a solar cell array on a glass substrate. It brings more complicated processes and a number of disadvantages for the automotive application such as non-transparency when used as a sunroof, high cost, and cell breakage during use.

A substrate of the thin film solar cell may be selected from any of glass, polymer, ceramic and graphite according to physical demands. Glass out of the above material is used as a transparent substrate to provide good light transmittance and can be used for manufacturing transparent thin film solar cells. Polymer is used as a flexible substrate for easily bending and folding, and is generally used for manufacturing bendable thin film solar cells. When the thin film solar cell serves as a photovoltaic product used for commonly seen objects such as a car or an integrated building structure, etc., on one hand, it is requested to have good light transmittance to ensure illuminating brightness in a carriage or an indoor space, and on the other hand, the solar cell is required to have good bending performance to be closely affixed to bending structural surfaces such as car sunroofs or building glass. In order to meet the two aspect requirements, the substrate of the thin film solar cell must be both transparent and bendable.

Most polymer substrates do not have good light transmittance and high temperature resistance at the same time. In other words, a transparent polymer substrate is unable to withstand a process temperature above 200°C. A thickness of glass substrates adopted in the existing thin film solar cell technology is generally greater than 3mm, and therefore the glass substrate has no bending capacity to be directly used to process and manufacture a bendable solar cell. Moreover, the existing manufacturing equipment and technical process of the thin film solar cell mostly are established based on a planar substrate, such as a flat float glass, etc. As a result, it is much difficult to directly manufacture a thin film solar cell with a certain bending curvature. If the thin film solar cell needs to be manufactured by uniformly film coating on a bending substrate, it requires big changes of film coating equipment and coating processes, and such changes not only make related cost increase sharply, but also result in large limitation of adaptive degrees of the existing equipment and processes for different products because different bending structural surfaces have different shapes and bending curvatures. Based on the above reasons, application of the thin film solar cell in the field of bendable products is not well developed to date.

BRIEF SUMMARY OF THE INVENTION

A glass substrate used for an existing thin film solar cell panel is too thick to have bending capacity so that the thin film solar cell panel cannot be used for making bending solar cell components. Furthermore, it is difficult to apply the manufacturing process of the existing thin film solar cell panel on manufacturing cell components with a certain bending curvature, and as a result, the process cannot be widely used for manufacturing bendable photovoltaic products.

In view of the above, an object of the present invention is to provide a thin film solar cell panel. A substrate of the thin film solar cell panel has a higher bending capacity and light transmittance. Hence, the thin film solar cell panel can be conveniently used to manufacture bending solar cell components having better light transmittance.

Another object of the present invention is to provide a manufacturing method of the thin film solar cell panel. The manufacturing method can be widely used to manufacture various thin film solar cell components with a range of bending curvature.

A thin film solar cell panel of the present invention includes a substrate, a first electrode disposed on the substrate, a photoelectric conversion layer disposed on the first electrode and a second electrode disposed on the photoelectric conversion layer, and further includes a gate electrode. The substrate is an ultra-thin glass substrate, and a thickness of the ultra-thin glass substrate is 0.1-1mm. The ultra-thin glass substrate has a bending capacity, and a minimum bending radius thereof is below 10cm. The first electrode is continuously disposed on the substrate during formation of the first electrode.

The thin film solar cell panel of the present invention has the following advantages. The ultra-thin glass substrate with a thickness of 0.1-1mm has the effect of increasing light transmittance so as to improve the light transmittance of the thin film solar cell panel. The ultra-thin glass substrate has better bending capacity so as to be capable of being conveniently used to manufacture bending solar cell components. Increase of light transmittance of the ultra-thin glass substrate helps to improve an absorption rate of the photoelectric conversion layer so that efficiency of the thin film solar cell panel is 1-2% higher than that of the existing thin film solar cell. Compared with a polymer substrate, the ultra-thin glass substrate also has advantages of high temperature resistance and good environment corrosion insulation performance. Compared with the traditional way that thin film solar cell is divided into a plurality of cell blocks on the substrate by insulating material, the way that the first electrode is continuously disposed on the substrate during the formation has the advantages that: the process is simple, and can be applied to a bending assembly to form a uniformly and continuously integrated structure through tight combination with a bending structure, and the integrated structure looks more beautiful.

Preferably, the bending radius of the ultra-thin glass substrate is greater than 30cm, and the thickness of the substrate is 0.35-1mm. The ultra-thin glass substrate has the following advantages that: in the case of reaching a certain bending radius required by a bending surface, it should choose a thicker ultra-thin glass as the substrate to improve the strength of the thin film solar cell panel.

Optionally, the first electrode is a full-transparent thin film, and the second electrode is a non-full-transparent thin film.

Preferably, the light transmittances of the first electrode and the second electrode are equal, and the first electrode and the second electrode are full-transparent thin films.

Preferably, each of the first electrode and the second electrode is a transparent conductive oxide, including one of zinc oxide, tin oxide, indium tin oxide and graphene.

Preferably, the photoelectric conversion layer includes one or more of an amorphous silicon film, a microcrystalline silicon film, a polycrystalline silicon film and a monocrystalline silicon film, and the amorphous silicon film, the polycrystalline silicon film or the monocrystalline silicon film forms a single-junction structure containing a p-n junction or p-i-n junction, or a multi-junction structure containing a plurality of p-n junctions or p-i-n junctions.

Preferably, the photoelectric conversion layer includes one or more of a cadmium telluride thin film, a copper indium gallium tin thin film and an organic semiconductor thin film.

Preferably, the thin film solar cell panel is used for a car, a ship or various integrated building structures.

Preferably, the thin film solar cell panel is used for a car sunroof; the gate electrode of the thin film solar cell panel is connected with a car power supply system and electrical loads thereof through wires, and the electrical loads include a fan, an illuminating lamp and an electronic entertainment system in a carriage.

Preferably, the thin film solar cell panel is used for a car sunroof, and the bending radius of the substrate is greater than 1m.

Preferably, the car sunroof includes car sunroof glass, the car sunroof glass has a lower surface towards the inside of the car and an upper surface towards the outside of the car, and the thin film solar cell panel is affixed to the upper surface of the car sunroof glass; the photoelectric conversion layer includes a P-type layer and an N-type layer, and the P-type layer is disposed adjacent to the first electrode. Preferably, the car sunroof includes car sunroof glass, the car sunroof glass has a lower surface towards the inside of the car and an upper surface towards the outside of the car, and the thin film solar cell panel is affixed to the lower surface of the car sunroof glass; the photoelectric conversion layer includes a P-type layer and an N-type layer, and the N-type layer is disposed adjacent to the first electrode. The present invention has the advantages that: as the migration rate of electrons in the amorphous silicon thin film is greater than that of holes, in the photoelectric conversion layer containing the P-I-N junction, the P-type layer is disposed on one side accepting irradiation of sunlight, the electrons generated in the P-type layer move further distance over an I-layer so as to be collected by the electrode, while the holes may be directly collected by the electrode adjacent to the P-type layer to improve the collection rate of the holes, and thus improving the photoelectric conversion efficiency of the cell.

Preferably, the thin film solar cell panel is used for a ship or an integrated building structure, and the bending radius of the substrate is greater than 30cm.

The present invention further provides a manufacturing method of a thin film solar cell panel, including the following steps:

S1, providing an ultra-thin glass substrate, wherein the thickness of the ultra-thin glass substrate is 0.1-1mm, the ultra-thin glass substrate has bending property, and the minimum bending radius thereof may reach below 10cm;

S2, depositing a first electrode, a photoelectric conversion layer and a second electrode sequentially on the ultra-thin glass substrate;

S3, after depositing the first electrode, the photoelectric conversion layer and the second electrode, dividing the solar cell into a plurality of small cell units in parallel connection or series connection through performing laser scribing to reduce resistance loss and improve energy conversion efficiency of the thin film solar cell;

S4, performing laser or a chemical etching treatment on the cell structure to increase the light transmittance;

S5, setting a gate electrode to form the thin film solar cell; and

S6, performing bending treatment on the thin film solar cell panel.

The manufacturing method of the thin film solar cell panel provided by the present invention has the following advantages. The manufacturing method of the thin film solar cell panel provided by the present invention is continuous during the formation of the layers of thin films, and the solar cell is cut into small cell units with laser scribing only in step S3 after coating, so that the manufacturing process is simpler, the manufacturing efficiency is improved, the thin film solar cell panel is tightly affixed to the bending structural surface to form an integrated structure, which looks more beautiful.

According to the manufacturing method of the thin film solar cell panel provided by the present invention, the solar cell panel with the bendable ultra-thin glass substrate is directly combined with a bending structural surface to form a firm solar cell component with a certain radius. As the ultra-thin glass substrate is still in a flat form during the coating process, process conditions do not require any change, thereby avoiding the problems occurred during manufacturing of the bending cell components and additionally increased cost, and greatly increasing general applicability of the equipment and manufacturing process to various bending cell components.

Preferably, a lamination process is used during the bending treatment to combine the thin film solar cell panel deposited on the ultra-thin glass substrate with a bending structure having a preset rigidity. The thin film solar cell panel is further packaged and isolated from surrounding environment, and thus a bending solar cell panel capable of working stably is formed.

Preferably, a bonding process is used during the bending treatment to combine the thin film solar cell panel with a bending structure having a preset rigidity to form the bending solar cell panel capable of working stably.

Preferably, the first electrode is made of a full-transparent conductive thin film, and the second electrode is made of a non-full-transparent thin film.

Preferably, light transmittances of the first electrode and the second electrode are equal, and the first electrode and the second electrode are made of totally transparent conductive thin films.

Preferably, each of the first electrode and the second electrode is made of a transparent electrically conductive oxide, including one of zinc oxides, tin oxides, indium tin oxides and graphene.

Preferably, a temperature in a manufacturing process of the first electrode and the second electrode is below 600°C. Further preferably, the first electrode and the second electrode are respectively manufactured by an LPCVD, MOCVD or APCVD method.

Preferably, the photoelectric conversion layer includes one or more of an amorphous silicon film, a microcrystalline silicon film, a polycrystalline silicon film and a monocrystalline silicon film. The amorphous silicon film, the microcrystalline silicon film, the polycrystalline silicon film or the monocrystalline silicon film forms a single-junction structure containing a p-n junction or p-i-n junction, or multi-junction structure containing a plurality of p-n junctions or p-i-n junctions.

Preferably, a process temperature in a manufacturing process of the photoelectric conversion layer is below 600°C. Further preferably, the photoelectric conversion layer is manufactured by a PECVD method.

Preferably, the photoelectric conversion layer includes one or more of a cadmium telluride thin film, a copper indium gallium tin thin film and an organic semiconductor thin film.

Preferably, the bending structure having a preset rigidity includes shaped bending glass and a metal structure component subjected to a surface insulation treatment.

Preferably, the bending glass is a car sunroof glass, marine structure glass or building glass, and the metal structure component subjected to a surface insulation treatment includes a car roof structure. Further preferably, the bending glass is a car sunroof glass, and the gate electrode of the thin film solar cell panel is electrically connected with a car power supply system and car electrical loads through conductive wires. The car electrical loads include a fan, an illuminating lamp and an electronic entertainment system in a carriage.

Preferably, the lamination process is conducted in an autoclave, or is conducted by a curved surface vacuum lamination method. Further preferably, material used for the lamination process is EVA, PVB or ionic bonding resin.

Preferably, a binder "Vertak®" produced by Du-Pont™ Company is selected to use for the bonding process.

BRIEF DESCRIPTION OF THE DRAWINGS

FIG. 1 is a schematic structural diagram of a thin film solar cell panel in accordance with a preferred embodiment of the present invention.

FIG. 2 is a schematic diagram showing change relationships between light transmittances of ultra-thin glass substrates with different thicknesses and light wavelengths.

FIG. 3 is a schematic diagram showing change relationships between bending stresses and bending radiuses of two thinner ultra-thin glass substrates chosen from substrates shown in FIG. 2.

FIG. 4 is a schematic diagram showing change relationships between bending stresses and bending radiuses of ultra-thin glass substrates with various thicknesses.

FIG. 5 is a schematic structural diagram of a thin film solar cell panel in accordance with a preferred embodiment of the present invention showing the thin film solar cell panel is used for a car sunroof.

FIG. 6 is a flow chart of a manufacturing method of a thin film solar cell panel in accordance with the present invention.

DETAILED DESCRIPTION OF THE EMBODIMENTS

The present invention will be described in detail in conjunction with preferred embodiments shown in the accompany drawings as follows. However, these described embodiments are not provided to limit the present invention. All variations of structures, methods or functions made by a person of ordinary skill in the art according to these embodiments are covered within the protection claim scope of the present invention.

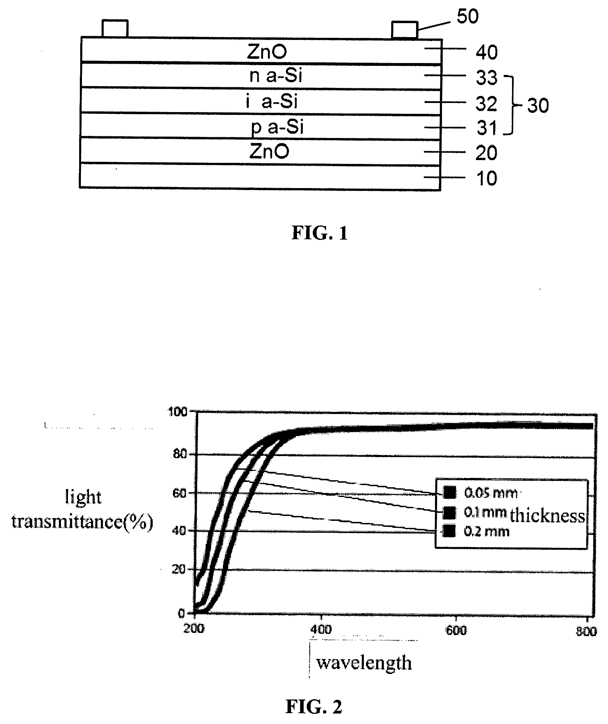

FIG. 1 is a schematic structural diagram of a thin film solar cell panel in accordance with a preferred embodiment of the present invention. With reference to FIG. 1, the thin film solar cell panel includes a substrate 10, a first electrode 20 disposed on the substrate 10, a photoelectric conversion layer 30 disposed on the first electrode 20, a second electrode 40 disposed on the photoelectric conversion layer 30 and a gate electrode 50 disposed on the second electrode 40. The substrate 10 is an ultra-thin glass substrate. A thickness of the ultra-thin glass substrate is 0.1-1mm. The ultra-thin glass substrate is capable of bending and a minimum bending radius thereof reaches below 10cm. The first electrode 20 is continuously disposed on the substrate 10 during its formation process. In the preferred embodiment of the present invention as shown in FIG. 1, the photoelectric conversion layer 30 includes an amorphous silicon p-type layer 31, an amorphous silicon intrinsic layer 32, and an amorphous silicon n-type layer 33. The first electrode 20 and the second electrode 40 are made of zinc oxide material.

The substrate 10 is selected from a variety of ultra-thin glass products of U.S. Corning® Incorporated, for example, Lotus™ Glass, Willow® Glass and Gorilla® Glass. FIG. 2 shows relationships between light transmittances of ultra-thin glasses and light wavelengths. With reference to FIG. 2, change relationships between light transmittances of ultra-thin glasses with three respective thicknesses of 0.05mm, 0.1 mm and 0.2mm and light wavelengths are similar and have an identical change pattern. When the light wavelength is within a light waveband of 200nm-350nm, the transmittance increases rapidly following increase of wavelengths. When the light wavelength is within a visible light waveband greater than 350nm, increase of the light transmittance slows down, and the light transmittance reaches to a number being gradually saturated to be a constant greater than 90%. However, within the light waveband of 200nm-350nm as above mentioned, for a specific wavelength, the thinner the thickness of the ultra-thin glass is, the higher the light transmittance becomes. In the existing thin film solar cell technology, glass with a thickness of 3.2mm is generally selected to make a substrate. It can be concluded as above that the light transmittance of the generally selected glass in the existing technology with respect to short wavelength lights is far less than the light transmittance of the ultra-thin glass. As a result, light transmittance of the thin film solar cell becomes much poor. Therefore, selecting the ultra-thin glass to make the substrate 10 can obtain an effect of increasing the light transmittance. In addition, when thinner glass is selected to make the substrate 10, the photoelectric conversion layer 30 has a higher absorption rate with respect to light within a short waveband. Thus, efficiency of the thin film solar cell is improved by 1-2%.

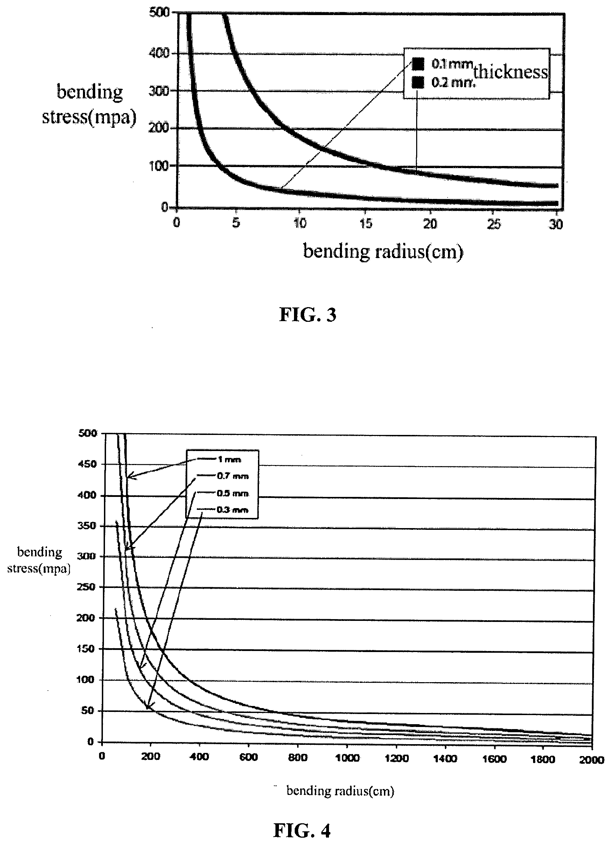

FIG. 3 shows relationships between bending stresses and bending radiuses of ultra-thin glasses with two respective thicknesses. With reference to FIG. 3, the bending stress of the ultra-thin glass with a thickness of 0.2mm corresponding to any bending radius is greater than the bending stress of the ultra-thin glass with a thickness of 0.1mm. Therefore, if the thickness of the glass is thinner, the bending stress of the glass corresponding to the same bending radius is smaller. The glass with the thinner thickness is much easier to be processed for bending and less likely to crack when being bent. For the ultra-thin glass with a thickness of 0.1mm, the bending stress thereof tends to approach 0 when the bending radius is in a large range from 10cm to 30cm. Only when the bending radius thereof is less than 10cm and approaching 5cm, the bending stress thereof increases significantly. If the minimum bending radius is defined as a bending radius when the glass reaches a specific threshold stress under certain processing conditions, the smaller the minimum bending radius is, the better the capacity of the glass to be bent will be. If the minimum bending radius is used to represent the excellent degree of bending capacity of the ultra-thin glass, it can be known from FIG. 3 that the ultra-thin glass with the thickness of 0.1mm has the optimal bending property, and the minimum bending radius thereof reaches below 10cm.

Therefore, another effect of using the ultra-thin glass to make the substrate 10 is to conveniently process flat thin film solar cell panels to make bending cell components with a certain curvature. The ultra-thin glass with a thinner thickness has good bending capacity, thus a solar component with a smaller bending radius can be manufactured. To specifically select the ultra-thin glass with what kind of thickness depends on the final curvature of the bending cell component, and if the curvature is greater, the ultra-thin glass with a much smaller minimum bending radius should be selected to make the substrate 10.

However, in practical applications, the smaller the thickness of the selected ultra-thin glass is, the weaker the strength of the selected ultra-thin glass becomes. Hence, the selected ultra-thin glass is easily damaged under external pressure or rainfall wash. Meanwhile, the selected ultra-thin glass is also easily broken in the manufacturing process to reduce the production yield and increase the manufacture cost. Therefore, on the premise of satisfying the actual bending requirement, it should select an ultra-thin glass being as thick as possible to make the substrate 10 to enhance the strength of the substrate 10. In general application of photovoltaic products, such as bending surfaces of a ship and a building, the minimum bending radius is 30cm while the minimum bending radius is greater than 1m for a car sunroof.

In general, a relationship between a surface bending stress and a thickness of the ultra-thin glass in the case that the ultra-thin glass is bent is:

$$\sigma = E\frac{t}{2R}$$

wherein $\sigma$ is the maximum surface bending stress, $t$ is the thickness of the ultra-thin glass, R is the bending radius, and E is the Young's modulus of the ultra-thin glass. FIG. 4 shows relationships between bending stresses and the bending radiuses for more substrates with a variety of thicknesses. With reference to FIG. 4, the bending capacity of the ultra-thin glass with a thickness below 1mm is very good. When the bending radius is 30cm, the maximum surface bending stress of an ultra-thin glass with a thickness of 0.5mm is about 60MPa, and the maximum surface bending stress of an ultra-thin glass with a thickness of 0.3mm is about 30MPa. If an ultra-thin glass with a thickness of 0.35mm is selected, according to the above formula using the Young's modulus of the glass as 90GPa substituted into the formula, it can be known that the maximum surface bending stress thereof is 52.5MPa. Although intrinsic strength of glass is approximately 200MPa, in practical applications, the maximum surface bending stress of the ultra-thin glass is required to be set as being about 50MPa in order to prevent breakage caused by surface defects. Therefore, the ultra-thin glass with a thickness of 0.35mm can satisfy the above mentioned requirement.

In a preferred embodiment of the present invention, the bending radius of the ultra-thin glass substrate is greater than 30cm, and thus the thickness of the ultra-thin glass substrate is 0.35-1mm. If there are special requirements to the strength of the substrate 10, the ultra-thin glass subjected to chemical toughening treatment, such as the Gorilla® glass of the Corning® Incorporated, etc., can also be selected to make the substrate 10.

Compared with a polymer substrate, the ultra-thin glass substrate also has the advantages of high temperature resistance and good performance of environment corrosion insulation.

Compared with the traditional technology to divide a plurality of cell blocks from a substrate with insulating material, the way used in the present invention that the first electrode 20 is continuously disposed on the substrate 10 has the advantages that processing thereof is simple, and that the solar cell panel of the present invention can be tightly integrated with a bending structure and the final integrated structure looks more beautiful when the present invention applies on bending components.

The light transmittances of the first electrode 20 and the second electrode 40 are equal, and the first electrode 20 and the second electrode 40 are made of totally transparent thin films. Due to use of the totally transparent thin films, more sunlight can penetrate through the car sunroof or the building glass to enhance illuminating brightness in a carriage or indoor illuminating brightness.

In other embodiments of the present invention, the first electrode 20 disposed on the substrate 10 is a totally transparent thin film while the second electrode 40 disposed on the photoelectric conversion layer 30 is a non-totally-transparent thin film. Using the non-totally-transparent thin film to make the second electrode 40 helps reflecting the light travelling through the photoelectric conversion layer 30 back to the photoelectric conversion layer 30 so as to increase the light absorption rate of the panel and enhance efficiency of the solar cell.

The first electrode 20 and the second electrode 40 are made of transparent electrically conductive oxides. In a preferred embodiment of the present invention as shown in FIG. 1, the first electrode 20 and the second electrode 40 are zinc oxide thin films. In other preferred embodiments of the present invention, the first electrode 20 and the second electrode 40 are made of one of zinc oxides, tin oxides, indium tin oxides and graphene.

The photoelectric conversion layer 30 includes one or more of an amorphous silicon film, a microcrystalline silicon film, a polycrystalline silicon film and a monocrystalline silicon film. The amorphous silicon film, the microcrystalline silicon film, the polycrystalline silicon film or the monocrystalline silicon film forms a single-junction structure containing a p-n junction or a p-i-n junction, or a multi-junction structure containing a plurality of p-n junctions or p-i-n junctions.

In other preferred embodiments of the present invention, the photoelectric conversion layer 30 includes one or more of a cadmium telluride thin film, a copper indium gallium tin thin film and an organic semiconductor thin film.

The thin film solar cell panel of the present invention is used for a car, a ship or various integrated building structures.

In a preferred embodiment of the present invention, the thin film solar cell panel is used for the car sunroof. The gate electrode of the panel is electrically connected with a car power supply system and car electrical loads through conductive wires. The car electrical loads include a fan, an illuminating lamp and an electronic entertainment system in a carriage. The bending radius of the substrate 10 is set to be greater than 1m, and thus thicker ultra-thin glass, such as ultra-thin glass with a thickness of 1mm, can be selected to make the substrate 10.

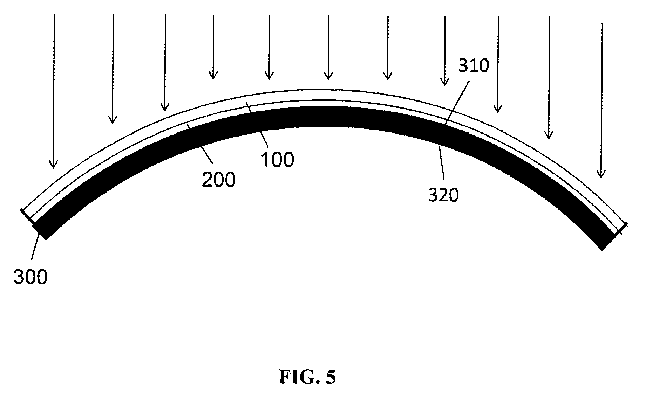

FIG. 5 is a schematic structural diagram of a thin film solar cell panel in accordance with a preferred embodiment of the present invention showing the thin film solar cell panel is used for a car sunroof. With reference to FIG. 5, the car sunroof includes the thin film solar cell panel and a car sunroof glass 300. The thin film solar cell panel includes an ultra-thin glass substrate 100 and a thin film cell set 200 disposed on the ultra-thin glass substrate 100. The thin film cell set 200 is consisted of the first electrode 20, the photoelectric conversion layer 30 and the second electrode 40 as above. The photoelectric conversion layer 30 includes the P-type layer 31 and the N-type layer 33. In some preferred embodiments of the present invention, the photoelectric conversion layer 30 further includes the I-type layer 32 disposed between the P-type layer 31 and the N-type layer 33.

The car sunroof glass 300 includes a lower surface 320 facing toward an inside of the car and an upper surface 310 facing toward an outside of the car. The thin film solar cell panel can be affixed to the upper surface 310 of the car sunroof glass 300 or the lower surface 320 of the car sunroof glass 300. With reference to FIG. 5 and FIG. 1, when the thin film solar cell panel is affixed to the upper surface 310 of the car sunroof glass 300, the P-type layer 31 is disposed immediately adjacent to the first electrode 20. On the other hand, when the thin film solar cell panel is affixed to the lower surface 320 of the car sunroof glass 300, the N-type layer 33 is disposed immediately adjacent to the first electrode 20. By means of the above arrangements, the P-type layer 31 always faces along a direction toward sunlight. Because the migration rate of electrons in the amorphous silicon thin film is greater than the migration rate of holes in the amorphous silicon thin film and the lifetime of the electrons is also longer than the lifetime of the holes, electrons generated near the P-type layer 31 can pass through the I-type layer 32 by means of drifting and diffusion movements and then be collected by the electrodes. However, if the N-type layer 33 becomes the window for light illumination to generate moving carriers, the holes generated near the N-type layer 33 are easily recombined and lost when passing through the I-type layer 32 due to its lower migration rate and shorter lifetime. Therefore, if the P-type layer 31 is set to always face along a direction toward sunlight, it is beneficial for enhancing a collection rate of the moving carriers and for further improving light energy conversion efficiency of the solar cell panel.

In other preferred embodiments of the present invention, when the thin film solar cell panel is used for ships or integrated building structures, the bending radius of the substrate 10 is greater than 30cm. As mentioned above, in this case, the ultra-thin glass with a thickness of more than 0.35mm can be selected to make the substrate 10.

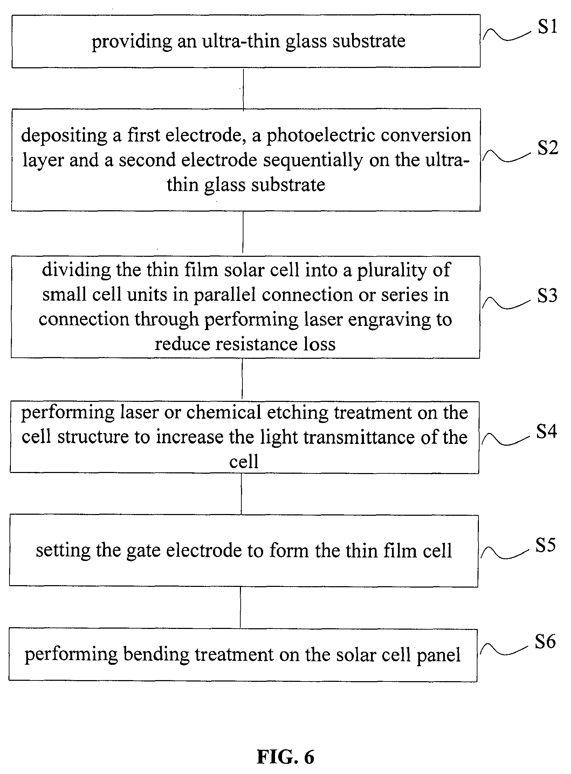

The present invention further provides a manufacturing method of a thin film solar cell panel. With reference to FIG. 6, the manufacturing method includes the following steps:

S 1. Providing an ultra-thin glass substrate, wherein the thickness of the ultra-thin glass substrate is 0.1-1mm, the ultra-thin glass substrate has a bending capacity, and the minimum bending radius thereof reaches below 10cm;

S2. Depositing a first electrode 20, a photoelectric conversion layer 30 and a second electrode 40 sequentially on the ultra-thin glass substrate;

S3. After depositing the first electrode 20, the photoelectric conversion layer 30 and the second electrode 40, dividing the solar cell panel into a plurality of smaller cell units in parallel connection or series connection through laser scribing respectively to reduce resistance loss and improve energy conversion efficiency of the cell;

S4. Performing a laser or chemical etching treatment on the cell structure to increase light transmittance of the cell structure;

S5. Disposing gate electrodes to form the thin film solar cell panel;

S6. Performing a bending treatment on the thin film solar cell panel.

According to existing processes for preparing thin film solar cells in the prior art, a plurality of smaller cell units are individually made first and then connected together. The existing processes in the art are more complex and have lower manufacturing efficiency. Furthermore, separated cell units in cell components finally formed do not form a continuous structure, and aesthetic of products is therefore affected. In the manufacturing method in accordance with the present invention, the first electrode 20 is continuously disposed on the substrate 10 during the formation of the first electrode 20. Similarly, the photoelectric conversion layer 30 is continuously disposed on the first electrode 20 during the formation of the photoelectric conversion layer 30 and the second electrode 40 is continuously disposed on the photoelectric conversion layer 30 during the formation of the second electrode 40. In the present invention, smaller cell units in parallel connection or series connection are formed by laser scribing only in step S3 after finishing of film deposition. No filling insulating substance is required in the cell units. Hence, the manufacturing process in the present invention is simpler and the manufacturing efficiency of the present invention is improved. In addition, the thin film layer of the whole cell panel is uniform and continuous, and is formed as an integrated structure so that its appearance looks more beautiful.

In the manufacturing method of the thin film solar cell panel in accordance with the present invention, after thin films are deposited on the flat ultra-thin glass substrate, the thin film solar cell panel is directly subjected to the bending treatment to form a final solid thin film solar cell panel with a certain bending curvature. Because the ultra-thin glass substrate is still in a flat form during the film deposition processes, any change of processing conditions are not required so as to avoid problems usually encountered during manufacturing of bending cell components and increase of additional cost, and to greatly increase general applicability of related equipment and manufacturing processes/methods onto various bending cell components.

In a preferred embodiment of the present invention, a lamination process is used during the bending treatment to combine the thin film solar cell deposited on the ultra-thin glass substrate with a bending structure having a certain or preset rigidity. The thin film solar cell panel is further packaged via the lamination process and isolated from surrounding environment to form the bending solar cell panel capable of working stably. The lamination process is conducted in an autoclave, or is performed by a curved surface vacuum lamination method. Material used for the lamination process is EVA (ethylene-vinyl acetate copolymer), PVB (polyvinyl butyral) or ionic bonding resin.

In other preferred embodiments of the present invention, a bonding process is used during the bending treatment to combine the thin film solar cell panel with a bending structure having a certain or preset rigidity, and thus the bending solar cell panel capable of working stably is formed. A binder "Vertak®" produced by DuPont™ Company is selected to use for the bonding process.

The bending structure with a certain or preset rigidity includes shaped bending glass and a metal structure component subjected to a surface insulation treatment. In a preferred embodiment of the present invention, the bending glass is car sunroof glass, marine structure glass or building glass, and the metal structure component subjected to the surface insulation treatment includes a car roof structure. When the bending glass is the car sunroof glass, the gate electrode of the thin film solar cell panel is electrically connected with a car power supply system and car electrical loads through conductive wires. The car electrical loads include a fan, an illuminating lamp and an electronic entertainment system in a carriage.

In a preferred embodiment of the present invention, the light transmittances of the first electrode 20 and the second electrode 40 are equal, and the first electrode 20 and the second electrode 40 are both made of totally transparent thin films to improve the light transmittance of the thin film solar cell panel. In other embodiments of the present invention, the first electrode 20 is made of a totally transparent thin film while the second electrode 40 is made of a non-transparent thin film. The non-transparent thin film can reflect light travelling through the photoelectric conversion layer 30 back to the photoelectric conversion layer 30 so as to increase the light absorption rate and improve the efficiency of the cell.

Each of the first electrode 20 and the second electrode 40 is made of transparent electrically conductive oxides, including one of zinc oxides, tin oxides, indium tin oxides or graphene.

The photoelectric conversion layer 30 includes one or more of an amorphous silicon film, a microcrystalline silicon film, a polycrystalline silicon film and a monocrystalline silicon film. In the preferred embodiment of the present invention as shown in FIG. 1, the photovoltaic conversion layer 30 is a p-i-n-type structure composed of an amorphous silicon N-type doped layer, an intrinsic layer and a P-type doped layer. Generally, the photovoltaic conversion layer 30 comprises a single-junction structure containing a p-n or p-i-n junction or a multi-junction structure containing a plurality of p-n junctions and p-i-n junctions when either the single-junction structure or the multi-junction structure is formed by the amorphous silicon film, the microcrystalline silicon film, the polycrystalline silicon film or the monocrystalline silicon film. In other preferred embodiments of the present invention, the photovoltaic conversion layer 30 includes one or more of a cadmium telluride thin film, a copper indium gallium tin thin film and an organic semiconductor thin film.

If a process temperature of the process method for manufacturing the first electrode 20, the second electrode 40 or the photoelectric conversion layer 30 is approaching the strain point of glass, the ultra-thin glass is easily deformed, and therefore the process temperature should be set to be away from the strain point of glass as far as possible. The strain point of the ultra-thin glass varies within a range of 650-700°C, and the strain point of other ultra-thin glass also varies within a similar temperature scope. Therefore, the process temperature of the process method of the present invention is below 600°C to prevent deformation of the ultra-thin glass substrate during deposition processing.

In general, an LPCVD (Low Pressure Chemical Vapor Deposition) method, an MOCVD (Metal-organic Chemical Vapor Deposition) method and an APCVD (Atmospheric Pressure Chemical Vapor Deposition) method are used to manufacture transparent oxide thin films. The process temperature of LPCVD is 180-210° C, the process temperature of MOCVD is as low as 500°C, and the process temperature of APCVD is about 450° C. The process temperature of PECVD used to manufacture a silicon based photoelectric conversion layer thin film is generally below 300°C. All of the above process methods meet the requirement that the process temperature is less than 600° C. Therefore, the first electrode 20 and second electrode 40 are manufactured through the LPCVD, MOCVD or APCVD process method, and the photoelectric conversion layer 30 is manufactured through the PECVD process method.

Although preferred embodiments of the present invention have been disclosed above, the present invention is not limited thereto. Any person skilled in the art can make various changes and modifications without departing from the spirit and scope of the present invention. Therefore, the protection scope of the present invention should be subjected to the scope defined by the appended claims. To a person skilled in the art, the present invention is obviously not limited to the details of the above exemplary embodiments, and the present invention can be implemented in other embodiments without departing from the spirit or essential features of the present invention. Therefore, no matter from which point of view, the embodiments as above should be considered to be exemplary and non-limited. The scope of the present invention is defined by the appended claims instead of the above descriptions. It is intended to encompass all changes within the meaning and scope of equivalents of the appended claims. Any reference numerals in the appended claims should not be contemplated as limiting the involved claims.

Moreover, it should be understood that the above descriptions are described according to embodiments of the present invention, but it is not the fact that every described embodiment merely comprises one independent technical solution. The illustrating way of the specification is only used for the sake of clarity. The person skilled in the art should treat the specification as an integrity, and the technical solutions in each of the described embodiments can also be properly combined to form other embodiments that can be understood by the person skilled in the art.

## Claims

1. A thin film solar cell panel, comprising a substrate, a first electrode disposed on the substrate, a photoelectric conversion layer disposed on the first electrode and a second electrode disposed on the photoelectric conversion layer, wherein the thin film solar cell panel further comprises a gate electrode, the substrate is an ultra-thin glass substrate, a thickness of the ultra-thin glass substrate is 0.1-1mem, the ultra-thin glass substrate has a bending capacity and a minimum bending radius thereof reaches below 10cm, and the first electrode is continuously disposed on the substrate during formation of the first electrode.

2. The thin film solar cell panel according to claim 1, wherein a bending radius of the ultra-thin glass substrate is greater than 30cm, and the thickness of the ultra-thin glass substrate is 0.35-1mm.

3. The thin film solar cell panel according to claim **1**, wherein the first electrode is made of a totally transparent thin film, and the second electrode is made of a non-totally-transparent thin film.

4. The thin film solar cell panel according to claim **1**, wherein the light transmittances of the first electrode and the second electrode are equal, and the first electrode and the second electrode are made of totally transparent thin films.

5. The thin film solar cell panel according to any of claims **2** to **4**, wherein each of the first electrode and the second electrode is made of a transparent electrically conductive oxide, comprising one of zinc oxides, tin oxides, indium tin oxides and graphene.

6. The thin film solar cell panel according to claim **5**, wherein the photoelectric conversion layer comprises one or more of an amorphous silicon film, a microcrystalline silicon film, a polycrystalline silicon film and a monocrystalline silicon film, and the amorphous silicon film, the microcrystalline silicon film, the polycrystalline silicon film or the monocrystalline silicon film forms a single-junction structure containing a p-n junction or a p-i-n junction, or a multi-junction structure containing a plurality of p-n junctions or p-i-n junctions.

7. The thin film solar cell panel according to claim **5**, wherein the photoelectric conversion layer comprises one or more of a cadmium telluride thin film, a copper indium gallium tin thin film and an organic semiconductor thin film.

8. The thin film solar cell panel according to claim **7**, wherein the thin film solar cell panel is used in a car, a ship or various integrated building structures.

9. The thin film solar cell panel according to claim **8,** wherein the thin film solar cell panel is used for a car sunroof; the gate electrode is electrically connected with a car power supply system and car electrical loads through conductive wires, and the car loads include a fan, an illuminating lamp and an electronic entertainment system in a carriage.

10. The thin film solar cell panel according to claim **8,** wherein the thin film solar cell panel is used for a car sunroof of a car, and the bending radius of the substrate is greater than 1m.

11. The thin film solar cell panel according to claim **10,** wherein the car sunroof comprises a car sunroof glass, the car sunroof glass has a lower surface facing toward an inside of the car and an upper surface facing toward an outside of the car, the thin film solar cell panel is affixed to the upper surface of the car sunroof glass, the photoelectric conversion layer comprises a P-type layer and an N-type layer, and the P-type layer is disposed immediately adjacent to the first electrode.

12. The thin film solar cell panel according to claim **10,** wherein the car sunroof comprises a car sunroof glass, the car sunroof glass has a lower surface facing toward an inside of the car and an upper surface facing toward an outside of the car, the thin film solar cell panel is affixed to the lower surface of the car sunroof glass, the photoelectric conversion layer comprises a P-type layer and an N-type layer, and the N-type layer is disposed immediately adjacent to the first electrode.

13. The thin film solar cell panel according to claim **8,** wherein the thin film solar cell panel is used for a ship or an integrated building structure, and the bending radius of the substrate is greater than 30cm.

14. A manufacturing method of the thin film solar cell panel according to any of claims **1-13,** comprising:

S1. providing an ultra-thin glass substrate, wherein a thickness of the ultra-thin glass substrate is 0.1-1mm, the ultra-thin glass substrate has a bending capacity, and a minimum bending radius thereof is below 10cm;
S2. depositing a first electrode, a photoelectric conversion layer and a second electrode sequentially on the ultra-thin glass substrate;
S3. dividing the solar cell panel into a plurality of smaller cell units in parallel connection or series connection through laser scribing respectively to reduce resistance loss and improve cell energy conversion efficiency after depositing the first electrode, the photoelectric conversion layer and the second electrode;
S4. performing a laser or chemical etching treatment on a cell structure of the solar cell panel to increase light transmittance of the cell structure;
S5. setting the gate electrode to form the thin film solar cell panel; and
S6. performing a bending treatment on the solar cell panel.

15. The manufacturing method of the thin film solar cell panel according to claim **14,** wherein a lamination process is used during the bending treatment to combine the thin film solar cell panel deposited on the ultra-thin glass substrate with a bending structure having a preset rigidity, the thin film solar cell panel is further packaged through the lamination process and isolated from surrounding environment, and thus a bending solar cell panel capable of working stably is formed.

16. The manufacturing method of the thin film solar cell panel according to claim **14,** wherein a bonding process is used during the bending treatment to combine the thin film solar cell panel with a bending structure having a preset rigidity to form a bending solar cell panel capable of working stably.

17. The manufacturing method of the thin film solar cell panel according to claim **14,** wherein the first electrode is made of a totally transparent thin film, and the second electrode is made of a non-totally-transparent thin film.

18. The manufacturing method of the thin film solar cell panel according to claim **14,** wherein light transmittances of the first electrode and the second electrode are equal, and the first electrode and the second electrode are made of totally transparent thin films.

19. The manufacturing method of the thin film solar cell panel according to claim **17** or **18,** wherein the first electrode and the second electrode are made of transparent electrically conductive oxides, and the transparent electrically conductive oxide is one of zinc oxides, tin oxides, indium tin oxides and graphene.

20. The manufacturing method of the thin film solar cell panel according to claim **19,** wherein the temperature during a manufacturing process of the first electrode and the second electrode is below 600 °C.

21. The manufacturing method of the thin film solar cell panel according to claim **20,** wherein the first electrode and the second electrode are respectively manufactured by an LPCVD (Low-Pressure Chem-

ical Vapor Deposition), Metalorganic Chemical Vapor Deposition (MOCVD) or Atmospheric Pressure Chemical Vapor Deposition (APCVD) method.

22. The manufacturing method of the thin film solar cell panel according to claim **21,** wherein the photoelectric conversion layer comprises one or more of an amorphous silicon film, a microcrystalline silicon film, a polycrystalline silicon film and a monocrystalline silicon film, and the amorphous silicon film, the microcrystalline silicon film, the polycrystalline silicon film or the monocrystalline silicon film forms a single-junction structure containing a p-n junction or p-i-n junction, or multi-junction structure containing a plurality of p-n junctions or p-i-n junctions.

23. The manufacturing method of the thin film solar cell panel according to claim **22,** wherein a temperature during a manufacturing process of the photoelectric conversion layer is below 600 °C.

24. The manufacturing method of the thin film solar cell panel according to claim **23,** wherein the photoelectric conversion layer is manufactured by a Plasma-Enhanced Chemical Vapor Deposition (PECVD) method.

25. The manufacturing method of the thin film solar cell panel according to claim **14,** wherein the photoelectric conversion layer comprises one or more of a cadmium telluride thin film, a copper indium gallium tin thin film and an organic semiconductor thin film.

26. The manufacturing method of the thin film solar cell panel according to claim **15,** wherein the bending structure having a preset rigidity comprises shaped bending glass and a metal structure component subjected to a surface insulation treatment.

27. The manufacturing method of the thin film solar cell panel according to claim **26,** wherein the bending glass is a car sunroof glass, marine structure glass or building glass, and the metal structure component subjected to a surface insulation treatment comprises a car roof structure.

28. The manufacturing method of the thin film solar cell panel according to claim **27,** wherein the bending glass is a car sunroof glass, the gate electrode of the thin film solar cell panel is electrically connected with a car power supply system and car loads through conductive wires, and the car loads comprise a fan, an illuminating lamp and an electronic entertainment system in a carriage.

29. The manufacturing method of the thin film solar cell panel according to claim **26,** wherein the lamination process is conducted in an autoclave, or is conducted by using a curved surface vacuum lamination method.

30. The manufacturing method of the thin film solar cell panel according to claim **29,** wherein material used in the lamination process is selected from Ethylene-Vinyl Acetate Copolymer (EVA), Polyvinyl Butyral (PVB) and ionic bonding resin.

31. The manufacturing method of the thin film solar cell panel according to claim **16,** wherein in the bonding process, a binder "Vertak®" produced by DuPont™ Company is selected to use.

**FIG. 1**

**FIG. 2**

**FIG. 3**

**FIG. 4**

**FIG. 5**

| providing an ultra-thin glass substrate | $\curvearrowright$ S1 |

| depositing a first electrode, a photoelectric conversion layer and a second electrode sequentially on the ultra-thin glass substrate | $\curvearrowright$ S2 |

| dividing the thin film solar cell into a plurality of small cell units in parallel connection or series in connection through performing laser engraving to reduce resistance loss | $\curvearrowright$ S3 |

| performing laser or chemical etching treatment on the cell structure to increase the light transmittance of the cell | $\curvearrowright$ S4 |

| setting the gate electrode to form the thin film cell | $\curvearrowright$ S5 |

| performing bending treatment on the solar cell panel | $\curvearrowright$ S6 |

**FIG. 6**

# INTERNATIONAL SEARCH REPORT

| International application No. |
|---|
| **PCT/CN2014/076723** |

## A. CLASSIFICATION OF SUBJECT MATTER

H01L 31/042 (2014.01) i; H01L 31/18 (2006.01) i

According to International Patent Classification (IPC) or to both national classification and IPC

## B. FIELDS SEARCHED

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

WPI, EPODOC: zinc, zincum, organic, solar cell, flexible, glass, substrate, thickness, thin film

CPRS, CNKI: zinc, oxide, solar cell, flexibility, curve, glass, substrate, thickness, thick

## C. DOCUMENTS CONSIDERED TO BE RELEVANT

| Category* | Citation of document, with indication, where appropriate, of the relevant passages | Relevant to claim No. |
|---|---|---|
| Y | CN 101714583 A (ZHEJIANG ASTRONERGY SOLAR ENERGY TECHNOLOGY CO., LTD.), 26 May 2010 (26.05.2010), description, paragraphs [0002]-[0035], and figures 1-3 | 1-31 |
| Y | CN 102945869 A (CHANGCHUN GUANGJING SCIENCE & TECHNOLOGY CO., LTD.), 27 February 2013 (27.02.2013), description, paragraphs [0002]-[0009], and figure 1 | 1-31 |
| PX | CN 103258881 A (YANG, Liyou), 21 August 2013 (21.08.2013), the whole document | 1-31 |
| PX | CN 203218290 U (YANG, Liyou), 25 September 2013 (25.09.2013), the whole document | 1-13 |
| PX | CN 103296114 A (YANG, Liyou), 11 September 2013 (11.09.2013), the whole document | 1-31 |
| PX | CN 203211094 U (YANG, Liyou), 25 September 2013 (25.09.2013), the whole document | 1-13 |

☐ Further documents are listed in the continuation of Box C.      ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 14 July 2014 (14.07.2014) | **24 July 2014 (24.07.2014)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **DUAN, Xiaojin** Telephone No.: (86-10) **62411592** |
|---|---|

Form PCT/ISA/210 (second sheet) (July 2009)

## INTERNATIONAL SEARCH REPORT
### Information on patent family members

| International application No. |
| --- |
| **PCT/CN2014/076723** |

| Patent Documents referred in the Report | Publication Date | Patent Family | Publication Date |
| --- | --- | --- | --- |
| CN 101714583 A | 26 May 2010 | CN 101714583 B | 15 February 2012 |
| CN 102945869 A | 27 February 2013 | None | |
| CN 103258881 A | 21 August 2013 | None | |
| CN 203218290 U | 25 September 2013 | None | |
| CN 103296114 A | 11 September 2013 | None | |
| CN 203211094 U | 25 September 2013 | None | |

Form PCT/ISA/210 (patent family annex) (July 2009)

**EP 2 996 160 A1**

## REFERENCES CITED IN THE DESCRIPTION

### Patent documents cited in the description

- US 5602457 A
- EP 0393437 A